(19) Europäisches Patentamt
European Patent Office
Office européen des brevets

(11) **EP 4 364 536 B1**

(12) **EUROPÄISCHE PATENTSCHRIFT**

(45) Veröffentlichungstag und Bekanntmachung des Hinweises auf die Patenterteilung:
**29.01.2025 Patentblatt 2025/05**

(21) Anmeldenummer: **21790901.9**

(22) Anmeldetag: **13.10.2021**

(51) Internationale Patentklassifikation (IPC):
*H05K 1/09* (2006.01)     *H05K 3/12* (2006.01)
*H01B 1/20* (2006.01)     *H01B 1/22* (2006.01)
*H01B 1/24* (2006.01)

(52) Gemeinsame Patentklassifikation (CPC):
**H01B 1/24; H05K 1/095; H05K 3/1241;**
H05K 2201/0329

(86) Internationale Anmeldenummer:
**PCT/EP2021/078319**

(87) Internationale Veröffentlichungsnummer:
**WO 2023/061578 (20.04.2023 Gazette 2023/16)**

(54) **ELEKTRISCH LEITFÄHIGE ELASTOMERE DRUCKTINTE FÜR KONTAKTLOSE DRUCKVERFAHREN**

ELECTRICALLY CONDUCTIVE ELASTOMER PRINTING INK FOR CONTACTLESS PRINTING PROCESSES

ENCRES ÉLASTOMÈRES ÉLECTROCONDUCTRICES POUR L'IMPRESSION SANS CONTACT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**08.05.2024 Patentblatt 2024/19**

(73) Patentinhaber: **Wacker Chemie AG**
**81671 München (DE)**

(72) Erfinder:
• **SURARU, Sabin-Lucian**
**81671 München (DE)**
• **KÖLLNBERGER, Andreas**
**81671 München (DE)**

(74) Vertreter: **Mieskes, Klaus Theoderich et al**
**Wacker Chemie AG**
**Gisela-Stein-Straße 1**
**81671 München (DE)**

(56) Entgegenhaltungen:
**WO-A1-2011/161598      WO-A1-2015/127290**
**US-A1- 2014 014 403**

• **DAVID MCCOUL ET AL: "Inkjet 3D printing of UV and thermal cure silicone elastomers for dielectric elastomer actuators", SMART MATERIALS AND STRUCTURES, IOP PUBLISHING LTD., BRISTOL, GB, vol. 26, no. 12, 10 November 2017 (2017-11-10), pages 125022, XP020322030, ISSN: 0964-1726, [retrieved on 20171110], DOI: 10.1088/1361-665X/AA9695**

**Beschreibung**

Die Erfindung betrifft ein Verfahren zur Herstellung einer elektrisch leitfähigen, vernetzenden Silikonelastomerzusammensetzung als elektrisch leitfähige Drucktinte in kontaktlosen Druckverfahren zur Herstellung von Elektroden für Sensoren, Aktoren oder EAP-Schichtsysteme.

Elektrisch leitfähige Drucktinten werden für die Herstellung von gedruckter Elektronik eingesetzt, um in elektronischen Bauteilen großflächig oder strukturiert Elektroden durch ein beliebiges Druckverfahren auf ein Substrat aufzubringen. Der Druck von elektrisch leitfähigen Elastomeren auf einen elastischen Träger (wie z.B. Silikon, TPU) ermöglicht den Aufbau von vollständig oder teilweise elastischen elektronischen Bauteilen, die auch bei Dehnung oder Stauchung die elektrischen Eigenschaften nahezu unverändert beibehalten. Zudem können elektrisch leitfähige Elastomerdrucktinten auf flexiblen (aber nicht dehnbaren) Substraten gedruckt werden, wie z.B. auf PET, PE, PTFE oder Papier um auch bei dauerhafter mechanischer Belastung durch mehrfaches Biegen die mechanische Schädigung der gedruckten Elektrode gering zu halten und somit eine Veränderung der elektrischen Leitfähigkeit durch beispielsweise Anstieg des Widerstandes zu verhindern. Leitfähige Drucktinten für die gedruckte Elektronik sind bekannt und teilweise auch kommerziell erhältlich. Sie enthalten typischerweise mindestens ein polymeres Bindemittel, mindestens eine leitfähige Komponente wie z.B. Metall- oder Kohlenstoffpartikel und mindestens ein Lösungsmittel zum Einstellen der Viskosität. Grundsätzlich haben leitfähige Kohlenstoffpartikel wie z. B. Ruß und Kohlenstoffnanoröhren (CNT) als Füllstoff den Nachteil, dass sie die Viskosität der Formulierung stark anheben, was die Verdruckbarkeit der Tinte deutlich erschwert, so dass typischerweise Lösungsmittel zur Verdünnung eingesetzt werden, um die effektive Konzentration der Partikel in der Drucktinte zu reduzieren und die Drucktinte so applizierbar zu machen. US9253878 beschreibt eine solche Formulierung basierend auf einem Silikon-Elastomer, Leitfähigkeitsruß sowie CNT, wobei Letztere dadurch gekennzeichnet sind, dass sie mindestens 30 nm dick sind. Letztere Eigenschaft verleiht der lösungsmittelhaltigen, leitfähigen Drucktinte eine gute Verdruckbarkeit im Siebdruck, was mit dünnen CNT (< 30 nm) nicht möglich sei. Die Formulierung kommt dennoch nicht ohne Lösungsmittel aus.

US2016351289 beschreibt, dass ein Lösungsmittelgehalt von mindestens 10% in einer Silikon-basierten leitfähigen Drucktinte enthalten sein muss, damit sie applizierbar ist. Typischerweise werden im Bereich der Silikondrucktinten organische Lösungsmittel eingesetzt, welche im Anschluss nur sehr schwer vollständig entfernt werden können und für den Anwender hinsichtlich Arbeits- und Umweltschutz einen hohen Kostenaufwand mitsichbringen.

CNT-haltige Silikon-Elastomere sind bekannt. Siliconeelastomere die sowohl CNT als auch Ruß enthalten, werden in CN103160128 beschrieben. Die hier beschriebenen Silikon-Elastomere zeichnen sich durch einen hohen Rußanteil aus. Beansprucht werden mindestens 3.7 Gew% Ruß, die Beispiele zeigen jedoch, dass um gute elektrische Eigenschaften zu erhalten, so dass der spezifische Widerstand < 20 Ohm*cm beträgt, ein Gesamtfüllstoffgehalt (CB + CNT) von mindestens 8.5% notwendig ist. Es wird kein Druckverfahren unter Verwendung dieser Zusammensetzugen offenbart.

Lösungsmittel-freie Silikon-basierte Drucktinten sind nur wenig bekannt: z.B. in US2014060903 wird eine lösungsmittelfreie, Silikon-basierte, leitfähige Drucktinte beschrieben, die allerdings keine leitfähigen Partikel mit hohem Aspektverhältnis enthält (wie z.B. Kohlenstoffnanoröhren = CNT) und somit nicht für dehnbare Anwendungen geeignet ist. Für dehnbare Anwendungen, zu denen die dielektrischen Elastomersensoren, -aktoren und - generatoren gehören, werden dehnbare Bindemittel (Elastomere) in Kombination mit leitfähigen anisotropen Partikeln eingesetzt, die ein hohes Aspektverhältnis besitzen, typischerweise CNT. Das hohe Aspektverhältnis der leitfähigen Partikel sorgt dafür, dass die leitfähigen Partikel im Gegensatz zu sphärischen Partikeln bei geringeren Füllstoffmengen ein leitfähiges Netzwerk durch das gesamte System bilden können, das auch bei Dehnung des Elastomers Bestand hat. Damit bleibt eine gute Elektronenleitung auch bei Dehnung des Elastomers gewährleistet.

Die im Stand der Technik bekannten Verfahren zur Auftragung von Siliconschichten insbesondere solche, die zur Herstellung von Elektrodenschichten und/oder dielektrischer Schichten in Aktoren, Sensoren und anderen elektroaktiven Polymerschichtsystemen geeignet sind, sind in ihrer Variabilität, Auftragegenauigkeit, Durchsatz, sowie in der später erreichten Bauteileffektivität und Beständigkeit beschränkt.

Zur Auftragung von Schichten ist im Stand der Technik unter anderem das sogenannte Lasertransferdruck-Verfahren bekannt. Dieses Verfahren beschränkt sich jedoch in seiner Anwendung bisher auf niedrigviskose Tinten und Dispersionen sowie Metalle.

WO 2009/153192 A2 beschreibt beispielsweise ein Verfahren zur Herstellung leitfähiger Schichten auf Halbleiterstrukturen, wobei eine Metallpulverdispersion auf einen Träger aufgebracht und durch einen Laserstrahl vom Träger auf ein Target abgelöst wird.

WO 2010/069900 A1 beschreibt beispielsweise den Laser-Transferdruck von Farbe.

WO 2015/181810 A1 beschreibt ein Lasertransfer-Verfahren zum Drucken von metallischen Körpern. Ein Metallfilm auf einen transparenten Träger wird dabei punktuell erhitzt und in Form von Tropfen positioniert.

WO 2011/161598 A1 offenbart ein Verfahren zur Herstellung einer elektrisch leitfähigen, vernetzenden Silikonelastomerzusammensetzung aus - 0,1 bis 3,0 Gew.% mehrwandige Kohlenstoffnanoröhren (MWCNT) und ohne Verwendung eines Lösungsmittels.

US 2014/0014403 A1 beschreibt eine Elektrodenherstellungs- mischung aus aktivierten Kohlenstoff und MWCNT.

WO 2015/127290 A1 offenbart einen Elektrodenfilm aus Nanoteilchen vermischt mit MWCNT und ohne die Verwendung eines Lösungsmittels.

Die Veröffentlichung DAVID MCCOUL ET AL: "Inkjet 3D printing of UV and thermal cure silicone elastomers for dielectric elastomer actuators",SMART MATERIALS AND STRUCTURES, IOP PUBLISHING LTD., BRISTOL, GB, Bd. 26, Nr. 12, 10. November 2017 (2017-11-10), Seite 125022, XP020322030,ISSN: 0964-1726, DOI: 10.1088/1361 - 665X/AA9695 beschreibt eine Druckertinte für Elektroden bestehend aus MWCNT und Silikone.

Die Aufgabe der vorliegenden Erfindung war daher die Bereitstellung eines Verfahrens zur Herstellung elektrisch leitfähiger, vernetzender Silikonelastomerzusammensetzungen, welche trotz des gleichzeitigen Einsatzes von Leitfähigkeitsruß und CNT mit einem hohen Aspektverhältnis aber ohne den Einsatz von Lösungsmitteln auskommt, gleichzeitig aber gute Applikationseigenschaften als Drucktinte in drucklosen Auftragsverfahren wie bspw. dem Lasertransferdruckverfahren zeigt und nach dem Auftragen eine glatte Oberfläche die frei von Partikeln ist, liefert.

Überraschenderweise wurde in der vorliegenden Erfindung gefunden, dass eine elektrisch leitfähige Silicone-lastomerzusammensetzung basierend auf Leitfähigkeitsruß (0,5 - 3 Gew.%) und MWCNT (0,1 - 3 Gew.-%) ohne Zusatz eines Lösungsmittels als Drucktinte eingesetzt werden kann, um Elektroden für dielektrische Elastomersensoren und -aktoren zu drucken, wenn diese vor dem Druckprozess zur Druckfiltration durch eine Metallgewebe mit einer Maschenweite kleiner oder gleich 200 $\mu$m (insbesondere kleiner oder gleich 100 $\mu$m) geleitet wird. Das so erhaltene Druckbild besitzt eine glatte Oberfläche und ist frei von Zacken.

Es ist zweifelsohne überraschend, dass das Filtergewebe nicht sofort verstopft, wenn eine Paste, die Partikel mit hohem Aspektverhältnis (Verhältnis von Länge zu Durchmesser) von (L/B > 10, bevorzugt >100) enthält hindurch geleitet wird. Dies würde dazu führen, dass die leitfähigen Partikel aus der Paste entfernt werden würden und sich der Filtrationsschritt so negativ auf die elektrischen Eigenschaften des Materials auswirkt. Dies ist nicht der Fall: Sowohl der elektrische Widerstand der unvernetzten, filtrierten Drucktinte, also auch das elektrische Verhalten der daraus vulkanisierten Probe unter Dehnung bleiben konstant.

Um die Seitenzahl der Beschreibung der vorliegenden Erfindung nicht zu umfangreich zu gestalten, werden im Folgenden nur die bevorzugten Ausführungsformen der einzelnen Merkmale aufgeführt.

Der fachkundige Leser soll diese Art der Offenbarung aber explizit so verstehen, dass damit auch jede Kombination aus unterschiedlichen Bevorzugungsstufen explizit offenbart und explizit gewünscht ist.

Der Gegenstand der Erfindung ist daher ein Verfahrens zur Herstellung einer elektrisch leitfähigen, vernetz-enden Siliconelastomerzusammensetzung definiert durch den unabhängigen Anspruch 1.

Die erfindungsgemäß eingesetzten MWCNTs weisen bevorzugt ein Aspektverhältnis von L/B>10, insbesondere bevorzugt von L/B>100 auf.

Das bei der Druckfiltration eingesetzte Metallgewebe weist bevorzugt eine Maschenweite von höchstens 100 $\mu$m auf.

Die Methoden zur Dispergierung der leitfähigen Füllstoffe, zum Vermischen der Komponenten sowie für die Druckfiltration und die dabei verwendbaren Apparaturen sind dem Fachmann aus dem Stand der Technik hinreichend bekannt.

Die Dispergierung erfolgt beispielsweise mit einem Walzenstuhl, Kneter oder insbesondere einem Dissolver (Hochgeschwindigkeitsmischer), wobei üblicherweise zusätzlich ein Abstreifer eingesetzt wird, um eine gleichmäßige Verteilung der leitfähigen Füllstoffe zu erreichen. Bevorzugt wird ein Planetendissolver mit Abstreifer eingesetzt. Besonders bevorzugt wird ein Vakuum-Planetendissolver mit Abstreifer und Balkenrührer eingesetzt. Es können Dissolverscheiben mit beliebiger Anordnung und Anzahl an Zähnen eingesetzt werden.

Als Basismaterialien für die Silikonelastomerzusammensetzung können prinzipiell alle im Stand der Technik bekannten Silikonelastomerzusammensetzungen verwendet werden.

Es können beispielsweise additionsvernetzende, peroxidisch vernetzende, kondensationsvernetzende oder strahlenvernetzende Siliconelastomerzusammensetzungen verwendet werden. Bevorzugt sind peroxidisch oder additionsvernetzende Zusammensetzungen. Besonders bevorzugt sind additionsvernetzende Zusammensetzungen.

Die Siliconelastomerzusammensetzungen können ein- oder zweikomponentig formuliert sein. Die Vernetzung der Siliconelastomerzusammensetzungen erfolgt dabei durch Wärmezufuhr, UV-Licht und/oder Feuchtigkeit. Geeignet sind beispielsweise folgende Siliconelastomerzusammensetzungen: HTV (additionsvernetzend), HTV (strahlenvernetzend), LSR, RTV 2 (additionsvernetzend), RTV 2 (kondensations-vernetzend), RTV 1, TPSE (thermoplastisches Siliconelastomer), Thiol-En und Cyanacetamid vernetzende Systeme.

Die bevorzugten additionsvernetzenden Siliconelastomerzusammensetzungen enthalten im einfachsten Fall

(A) mindestens eine lineare Verbindung, die Reste mit aliphatischen Kohlenstoff-Kohlenstoff-Mehrfachbindungen aufweist,

(B) mindestens eine - bevorzugt lineare - Organopolysiloxan Verbindung mit Si-gebundenen Wasserstoffatomen, oder anstelle von (A) und (B) oder zusätzlich zu (A) und (B)

(C) mindestens eine lineare Organopolysiloxan Verbindung, die Si-C-gebundene Reste mit aliphatischen Kohlenstoff-Kohlenstoff Mehrfachbindungen und Si-gebundene Wasserstoffatome aufweist, und

(D) mindestens einen Hydrosilylierungskatalysator.

Zur Dispergierung können die Komponenten der erfindungsgemäßen Siloxanzusammensetzung in beliebiger Reihenfolge zugegeben und dispergiert werden.

In einer bevorzugten Ausführungsform des Verfahrens werden der Leitfähigkeitsruß und MWCNTs unabhängig voneinander in Teilen des Siloxans eingemischt und ggf. dispergiert, d.h. in unterschiedlichen Mischbehältern eingemischt und ggf. dispergiert, und anschließend werden die beiden Mischungen (Rußvormischung und MWCNT-Vormischung) unter Mischen mit ggf. weiteren Komponenten und ggf. weiteren Dispergieren vereinigt. In einer weiteren Ausführungsform des Verfahrens kann eine oder beide Vormischungen mittels eines Walzenstuhls hergestellt werden Es hat sich dabei als vorteilhaft erwiesen, die Rußvormischung mittels eines Walzenstuhls herzustellen.

In einer weiteren bevorzugten Ausführungsform des Verfahrens werden Leitfähigkeitsruß und MWCNTs gemeinsam in die Gesamtheit oder Teilen des eingesetzten Siloxans eingerührt und anschließend gemeinsam dispergiert. Anstelle des Rußfeststoffs kann auch hier eine im Vorfeld hergestellte Rußvormischung eingesetzt werden.

Die Menge an Siloxan, Leitfähigkeitsruß und MWCNTs kann dabei so bemessen sein, dass sie den angestrebten Feststoffanteilen von Leitfähigkeitsruß und MWCNTs in der fertigen Mischung entspricht, oder es kann auch ein sogenannter Masterbatch-Ansatz hergestellt werden. Dabei wird entweder die Siloxanmenge und/oder die Ruß- und MWCNT-Menge so bemessen, dass ein höherer Feststoffanteil in der Mischung resultiert, als später benötigt wird. Sowohl Ruß als auch MWCNTs können als Feststoff oder als im Vorfeld hergestellte Vormischungen eingesetzt werden. Nach Beendigung der Dispergierung kann die konzentrierte Feststoffdispersion auf den Feststoff-Zielwert mit weiterem Siloxan herunterverdünnt werden. Dies kann unmittelbar nach der Dispergierung oder auch später, ggf. in einem anderen Mischgerät, erfolgen. Zur Verdünnung kann dasselbe Siloxan oder ein anderes Siloxan werden.

Die Zugabe von MWCNT, Ruß und der Komponenten (A) bis (D) kann unabhängig vom genauen Verfahren jeweils portionsweise oder durch Zugabe der Gesamtmenge erfolgen.

Vor der eigentlichen Dispergierung kann es vorteilhaft sein, die Feststoffe bei einer niedrigeren Umlaufgeschwindigkeit der Mischwerkzeuge in das Siloxan einzurühren oder einzumischen. Auf diese Weise kann eine entsprechende Vorbenetzung der Feststoffe mit Siloxan erreicht werden.

Optional kann der Mischbehälter und damit das enthaltene Mischgut während der Dispergierung temperiert werden, d.h. durch Kühlen oder Heizen auf einer Zieltemperatur gehalten werden. Üblicherweise liegt die Temperatur in einem Bereich von 0 - 200 °C, bevorzugt in einem Bereich von 20 - 100 °C.

Optional kann das erfindungsgemäße Verfahren unter Vakuum durchgeführt werden. Bevorzugt erfolgt die Dispergierung, d.h. Dispergierintervalle inklusive Dispergierpausen, unter Vakuum. Das Vakuum beträgt üblicherweise < 1.000 mbar, bevorzugt < 800 mbar und besonders bevorzugt < 500 mbar.

Weiterhin kann es vorteilhaft sein, im Anschluss an die Dispergierung Vakuum anzulegen. Dies kann im gleichen Gerät wie die Dispergierung erfolgen, oder in einem anderen Apparat. Üblicherweise erfolgt das Anlegen von Vakuum unter Rühren. Das Vakuum beträgt üblicherweise < 1.000 mbar, bevorzugt < 800 mbar und besonders bevorzugt < 500 mbar.

Die Dispergierung erfolgt dann bei einer hohen Umlaufgeschwindigkeit der Dispergierwerkzeuge und insbesondere der Dissolver- scheibe. Der so erzielte hohe Leistungseintrag führt zu der gewünschten feindispersen Verteilung der leitfähigen Füllstoffe wie z.B. MWCNTs oder Ruß im Siloxan. Wesentlich für das Dispersionsergebnis, und damit für eine optimal hohe elektrische Leitfähigkeit der leitfähigen Siloxanmischung, ist dabei ein maximaler Leistungseintrag der Mischwerkzeuge. Der maximale Leistungseintrag ist dabei abhängig von den gewählten Mischwerkzeugen, deren geometrischer Anordnung, der Umlaufgeschwindigkeit insbesondere der Dissolverscheibe, der Temperatur und der effektiven Viskosität des Mischguts, d.h. der Viskosität des Siloxans, die unter anderem vom Polymeri sationsgrad des Siloxans abhängt und der zugesetzten Füllstoff-Menge.

Ein weiterer Gegenstand der vorliegenden Erfindung sind die elektrisch leitfähigen, vernetzenden Silikonelastomerzusammensetzung erhältlich nach dem erfindungsgemäßen Verfahren.

Ein weiterer Gegenstand der Erfindung ist die Verwendung der erfindungsgemäßen leitfähigen vernetzenden Silikonelastomerzusammensetzung als elektrisch leitfähige Drucktinte in kontaktlosen Druckverfahren zur Herstellung von elektrisch leitfähigen Elastomeren auf elastischen Trägern.

Wird die so hergestellte erfindungsgemäße elektrisch leitfähige, vernetzende Silikonelastomerzusammensetzung als Drucktinte bspw. in einem kontaktlosen Druckverfahren eingesetzt, so entsteht ein Druckbild, welches eine glatte Oberfläche besitzt, die frei von Partikeln (Zacken) ist. Dies ist von entscheidendem Vorteil, wenn mehrlagige Systeme hergestellt werden sollen, in denen das leitfähige Material zwischen weiteren Schichten eingebracht werden soll, z.B. durch Lamination oder Überschichten.

Kontaktlose Druckverfahren haben den Vorteil, dass der Bedruckstoff während des Druckprozesses eine möglichst geringe mechanische Belastung erfährt. Die erfindungsgemäße elektrisch leitfähige, vernetzende Silikonelastomerzusammensetzung kann als Drucktinte für andere kontaklose Druckverfahren wie z.B. Sprüh-, drop-on-demand-Verfahren oder der Lasertransferdruck (LIFT-Verfahren) eingesetzt werden. Bevorzugt wird sie im Lasertransferdruck (LIFT-Verfahren) eingesetz.

Die erfindungsgemäße elektrisch leitfähige, vernetzende Silikonelastomerzusammensetzung eignet sich besonders bevorzugt als Drucktinte zum Verdrucken von Elektroden für dielektrische Elastomersensoren, -aktoren und -generatoren und EAP-Schichtsystemen.

Ausführungsbeispiele

Die nachfolgenden Beispiele beschreiben die prinzipielle Ausführbarkeit der vorliegenden Erfindung, ohne jedoch diese auf die darin offenbarten Inhalte zu beschränken.

Die nachfolgenden Beispiele wurden bei einem Druck der umgebenden Atmosphäre, also bei etwa 1013 hPa, und, sofern nicht anders angegeben, bei Raumtemperatur, also etwa 23°C bzw. einer Temperatur, die sich beim Zusammengeben der Reaktanden bei Raumtemperatur ohne zusätzliche Heizung oder Kühlung einstellt, durchgeführt.

Chemikalien:

MWCNTs LUCAN BT1001M, Hersteller LG Chem Ltd., mittlerer Durchmesser laut Herstellerangaben: 10 nm

Zur Herstellung der Rußvormischung wurden 5 Gew.-% des Hochleitfähigkeitsrußes Ketjenblack EC-600JD (erhältlich bei Nouryon) in 95 Gew.-% ViPo 1.000 auf einem Dreiwalzenstuhl eingearbeitet.

ViPo 1.000: Vinyldimethylsiloxy-endständiges Polydimethylsiloxan mit einer Viskosität von 1.000 mPa*s, erhältlich bei Gelest Inc. unter der Produktbezeichnung DMS-V31 (Gelest-Katalog).

HPo 1.000: Hydridodimethylsiloxy-endständiges Polydimethylsiloxan mit einer Viskosität von 1.000 mPa*s, erhältlich bei Gelest Inc. unter der Produktbezeichnung DMS-H31 (Gelest-Katalog) .

Als Vernetzer wurde ein $\alpha,\omega$-Dimethylhydrogensiloxy-poly(dimethyl-methylhydrogen)siloxan (Viskosität 130 - 200 mm$^2$/s; 0,145 - 0,165 Gew.-%-H) eingesetzt.

Als Hydrosilylierungskatalysator wurde für einkomponentige Systeme ein Platinkomplex mit Phosphitliganden gewählt, wie in EP2050768B1 (Katalysator 6) beschrieben. Für zweikomponentige Systeme wurde WACKER® KATALYSATOR OL (erhältlich bei Wacker Chemie AG) eingesetzt.

1-Ethinyl-1-cyclohexanol ist erhältlich bei Sigma Aldrich (CAS-Nummer: 78-27-3).

Viskositätsmessung:

Die Messungen der Viskosität wurden an einem luftgelagerten MCR 302 Rheometer der Firma Anton Paar bei 25 °C durchgeführt. Es wurde ein Kegel-Platte-System (25 mm, 2°) mit einem Spaltmaß von 105 $\mu$m verwendet. Das überschüssige Material wurde bei einem Spalt-Abstand von 115 $\mu$m mit einem Spatel entfernt (getrimmt). Anschließend bewegte sich der Kegel auf 105 $\mu$m Spaltabstand, damit der komplette Spalt gefüllt ist. Vor jeder Messung wird eine "Vorscherung" durchgeführt, bei der die Scherhistorie durch die Probenvorbereitung, die Auftragung und das Trimmen gelöscht wird. Die Vorscherung erfolgt für 60 Sekunden bei Scherrate 10 s$^{-1}$, gefolgt von einer Ruhezeit von 300 Sekunden. Die Scherviskosität wird mittels eines Stufenprofils bestimmt, bei dem die Probe mit konstanter Scherrate von 1 s$^{-1}$, 10 s$^{-1}$ und 100 s$^{-1}$ für jeweils 100 Sekunden geschert wird. Alle 10 Sekunden wird ein Messwert aufgezeichnet, wodurch sich 10 Messpunkte pro Scherrate ergeben. Der Mittelwert aus diesen 10 Messpunkten ergibt die Scherviskosität bei der jeweiligen Scherrate.

Die Bestimmung des Speichermoduls G' erfolgte mittels eines Amplitudentests. Bei diesem Oszillationsversuch wird die Amplitude $\gamma$ von 0,01 auf 1000% variiert (bei einer Kreisfrequenz $\omega$ von 10 s$^{-1}$, logarithmische Rampe, 30 Messpunkte). Typischerweise findet sich bei geringen Amplitudenwerten der linearviskoelastische (LVE) Bereich, bei dem G', wenn über $\gamma$ doppellogarithmisch aufgetragen, einen Plateauwert aufweist. Der Plateauwert ist das zu bestimmende Speichermodul G'.

Widerstandsmessung:

Bei einer Vierleitermessung wird der Kontaktwiderstand nicht mitgemessen, da der Strom an zwei Kontakten angelegt wird und an zwei weiteren Kontakten die Spannung U des bereits durch die Probe geflossenen Stromes $I_U$ gemessen wird.

$$R = \frac{U}{I_U} \quad [\Omega]$$

Der Widerstand R von nicht vulkanisierten Siloxanen wird mit dem Multimeter Model 2110 5 ½ digit von Keithley Instrument und einer angefertigten Messapparatur aus PP Natur und Edelstahl-(1.4571)-Elektroden gemessen. Die Verbindung des Messgeräts mit den Elektroden erfolgt mittels Messingkontakten und Laborleitungen. Die Messapparatur ist eine Form mit definierten Maßen für L x B x H von 16 cm x 3 cm x 0,975 cm, in die das Siloxan zur Messung gestrichen wird. Die beiden äußeren flächigen Elektroden sind im Abstand von 16 cm angebracht, wodurch der Strom die ganze Probe durchströmt. Die beiden Punkt-Elektroden mit einem Durchmesser von 1 cm befinden sich in der Bodenplatte im Abstand von 12 cm (l) und messen die Spannung. Mit folgender Formel wird der spezifische Widerstand aus dem gemessenen Widerstand R berechnet.

$$\rho = \frac{R \cdot h \cdot w}{l} \quad [\Omega cm],$$

mit Probenhöhe h [cm], Probenbreite w [cm] und Elektrodenabstand l [cm]
(hier: h = 0,975 cm, w = 3 cm, l = 12 cm)

Widerstandsänderung unter Dehnung

Gemäß ISO 37 wurden die Drucktinten in Form einer 2 mm Platte vulkanisiert und der Schulterstab Typ 1 gestanzt. Der Prüfkörper wird einer Vierleitermessung unterzogen. Dieser wird mittig zwischen zwei elektrisch leitfähige Klemmbacken gespannt, so dass deren Abstand voneinander 84,0 mm beträgt. Die Klemmbacken, die die beiden äußeren elektrischen Kontakte darstellen, sind strukturiert, womit durch die Struktur ein Eindringeffekt ins Material (Einstechen) erreicht wird.
Die beiden inneren Kontakte werden dadurch hergestellt, dass zwei Schnellklemmen in 29,5 mm Entfernung von der jeweils nächsten Klemmbacke und in einem Abstand von 25 cm voneinander positioniert werden. Die beiden inneren Messklemmen werden mit Silberleitpaste vorbehandelt. Der so gemessene Widerstand ohne Dehnung (L=L$_0$) ist R$_0$. Die beiden äußeren Klemmbacken ermöglichen zusätzlich die uniaxiale Dehnung des Prüfkörpers und somit die Messung des Widerstands R der gedruckten Elektrode bei der Dehnung (L-L$_0$)/L$_0$ = 50%.

Mischmethoden:

Die Mischungen wurden in einem Labotop 1LA der Firma PC Laborsystem GmbH mit einem Fassungsvermögen von 1 Liter bei 300 mbar Vakuum und Raumtemperatur hergestellt. Als Werkzeuge wurden eine Dissolverscheibe (14 Zähne, Zähne 90° zur Scheibe, Durchmesser 52 cm), ein Balkenrührer (Standardwerkzeug) und ein Abstreifer mit Temperaturmessung verwendet. Für größere Ansätze wurde ein Labormischer (Mischtechnik Hoffmann & Partner GmbH Andrä - Wördern, Österreich) mit einem Fassungsvermögen von 10 L mit Zahn-Dissolverscheibe (vier Zähne, Durchmesser 98 mm), Balkenrührer und Abstreifer eingesetzt. Der doppelwandige Rührkessel wurde mit einem Thermostaten auf 19 °C Manteltemperatur eingestellt.
Zum Mischen der A und B Komponenten wurde ein Laborrührer (IKA RW20) mit 3-flügeligem Propellerrührer (R 1381) von der Firma IKA® -Werke GmbH & Co. KG, Staufen, Deutschland eingesetzt.
Es wurde ein Dreiwalzenstuhl der Firma EXAKT (Modell 50 I) eingesetzt. Der Walzenspalt wurde auf den minimalen Abstand eingestellt.

Filtration

Zur Druckfiltration wurde die Masse in einen zylindrischen Stahlbehälter (Fassungsvermögen 5 L) überführt, der nach oben hin offen und im Boden einen kreisrunden Auslass (Durchmesser 31,5 mm) besitzt. Daran ist ein doppelkonischer Auslass angebracht, in dessen Mitte sich ein kreisrundes Metalldrahtgewebe (Durchmesser 80 mm) befindet. Durch Absenken einer Pressplatte und einem Auspressdruck von 50 bar wurde die Masse vertikal aus dem Stahlbehälter und durch das Metalldrahtgewebe gepresst. Zum Absenken der Pressplatte wurde eine Austrageeinheit mit Hydraulik-Antrieb von der Firma PC Laborsystem eingesetzt.
Es wurden Metalldrahtgewebe der Firma PACO Paul GmbH & Co. KG oder GKD-Gebr. Kufferath AG aus Chrom-Nickelstahl (X5CrNi18-10, Werkstoff-Nr. nach DIN/DIN EN 1.4301) mit einer Maschenweite von 50 bzw. 25 μm eingesetzt.

**Beispiel 1 Herstellung des Masterbatches M1**

In einem Labormischer mit einem Fassungsvermögen von 10 L mit Zahn-Dissolverscheibe (Durchmesser 98 mm mit vier Zähnen), Balkenrührer und Abstreifer wurden MWCNT (36 g) und 1783 g der Rußvormischung in ViPo 1.000 (581 g) für 60 min bei 1800 rpm (Dissolver) und 50 rpm (Balkenrührer) eingemischt. Der doppelwandige Rührkessel wurde mit einem Thermostaten auf 19 °C Manteltemperatur eingestellt. Es wurde eine homogene, schwarze Paste mit einem spezifischen Widerstand von 5,4 $\Omega$*cm erhalten. Die Viskosität beträgt bei Scherrate 10 s$^{-1}$ 296 Pa*s und das Speichermodul G' im LVE-Bereich 51200 Pa.

**Beispiel 2 Herstellung des Masterbatches M2**

Es wurden MWCNT (1.0 g) und 50,9 g der Rußvormischung in ViPo 1.000 (16,6 g) mit einem Balkenrühren (80 rpm, Labotop ohne Dissolverscheibe) eingerührt (1 min) und anschließend zweimal mit dem Dreiwalzenstuhl eingearbeitet. Es wurde eine homogene, schwarze Paste mit einem spezifischen Widerstand von 6,1 Q*cm erhalten. Die Viskosität beträgt bei Scherrate 10 s$^{-1}$ 280 Pa*s und das Speichermodul G' im LVE-Bereich 48800 Pa.

**Beispiel 3 Herstellung des Masterbatches M3**

5.0 g MWCNT wurden in 245 g ViPo 1000 mit einem Balkenrühren (80 rpm, Labotop ohne Dissolverscheibe) eingerührt (1 min) und anschließend zweimal mit dem Dreiwalzenstuhl eingearbeitet. Es wurde eine homogene schwarze Paste mit einem spezifischen Widerstand von 6,9 $\Omega$*cm erhalten. Die Viskosität beträgt bei Scherrate 10 s$^{-1}$ 80 Pa*s und das Speichermodul G' im LVE-Bereich 17000 Pa.

**Beispiel 4 Herstellung der Drucktinte 1a**

In einem Labormischer Labotop 1LA der Firma PC Laborsystem GmbH mit Zahn-Dissolverscheibe (Durchmesser 52 mm) wurden 0,8 Gew.-% MWCNT (4,0 g) und 200 g der Rußvormischung in eine Mischung aus ViPo 1.000 (108 g), HPo 1.000 (154 g), Vernetzer (20,0 g), Pt-Katalysator (0,4 g) und 1-Ethinyl-1-cyclohexanol (30°mg) für 60 Minuten bei Raumtemperatur, 2.000 rpm (Dissolver) und 200 rpm (Balkenrührer) eingemischt. Die erhaltene Paste wurde unter Druck durch ein Metallgewebe mit einer Maschenweite von 50 $\mu$m gepresst. Es wurde eine homogene, schwarze Paste erhalten.

**Beispiel 5 Herstellung der Drucktinte 1b**

Drucktinte 1b wurde analog zu Drucktinte 1a hergestellt, mit dem Unterschied, dass die Paste durch ein Metallgewebe mit einer Maschenweite von 25 $\mu$m gepresst wurde.

**Beispiel 6 Herstellung der Drucktinte 1c (nicht erfindungsgemäß)**

Drucktinte 1c wurde analog zu Drucktinte 1a hergestellt, mit dem Unterschied, dass die Paste nicht durch ein Metallgewebe gepresst wurde.

**Beispiel 7 Herstellung der Drucktinte 2a**

Der Masterbatch M1 aus Beispiel 1 wurde zu einer platinhaltigen Komponente A und einer platinfreien Komponente B verdünnt:
Zur Herstellung der A-Komponente wurden 1000 g des Masterbatch M1 mit Vipo 1000 (855 g) und WACKER® KATALYSATOR OL (3,7 g) für 30 min mit einem Balkenrühren (100 rpm, Labormischer ohne Dissolverscheibe) 30 min gemischt. Daraufhin wurde die Probe unter Druck durch ein Metallgewebe (Maschenweite 50 pm) gepresst. Komponente B wurde analog zu Komponente A hergestellt mit dem Unterschied, dass 1000 g des Masterbatch M1 mit HPo 1000 (465 g), Vernetzer (260 g), Vipo 1000 (134 g) und 1-Ethinyl-1-cyclohexanol (2,6 g) gemischt wurde. Daraufhin wurde die Probe durch ein Metallgewebe (Maschenweite 50 pm) gepresst.
Zur Herstellung der Drucktinte 2b wurden die Komponenten A und B im Verhältnis 1:1 für 1 min mit einem Propellerrührer (800 rpm) gemischt. Es wurde eine homogene, schwarze Paste erhalten.

**Beispiel 8 Herstellung der Drucktinte 2b (nicht erfindungsgemäß)**

Drucktinte 2b wurde analog zu Drucktinte 2a hergestellt, mit dem Unterschied, dass die beiden Komponenten A und B vor dem Mischen nicht durch ein Metallgewebe gepresst wurden. Es wurde eine homogene, schwarze Paste erhalten.

**Beispiel 9 Herstellung der Drucktinte 3a**

Der Masterbatch M2 aus Beispiel 2 wurde zu einer platinhaltigen Komponente A und einer platinfreien Komponente B verdünnt:
Zur Herstellung der A-Komponente wurden 30 g des Masterbatch M2 mit Vipo 1000 (25,7 g) und WACKER® KATALYSATOR OL (0,11 g) für 30 min mit einem Balkenrühren (80 rpm, Labotop ohne Dissolverscheibe) für 30 min gemischt. Daraufhin wurde die Probe unter Druck durch ein Metallgewebe (Maschenweite 50 pm) gepresst. Komponente B wurde analog zu Komponente B hergestellt mit dem Unterschied, dass 30 g des Masterbatch M2 mit HPo 1000 (14,0 g), Vernetzer (7,8 g), Vipo 1000 (4,02 g) und 1-Ethinyl-1-cyclohexanol (78 μg) gemischt wurde. Daraufhin wurde die Probe durch ein Metallgewebe (Maschenweite 50 pm) gepresst.
Zur Herstellung der Drucktinte 3a wurden die Komponenten A und B im Verhältnis 1:1 für 1 min mit einem Propellerrührer (800 rpm) gemischt. Es wurde eine homogene, schwarze Paste erhalten.

**Beispiel 10 Herstellung der Drucktinte 3b (nicht erfindungsgemäß)**

Drucktinte 3b wurde analog zu Drucktinte 3a hergestellt, mit dem Unterschied, dass die beiden Komponenten vor dem Mischen nicht durch ein Metallgewebe gepresst wurden. Es wurde eine homogene, schwarze Paste erhalten.

**Beispiel 11 Herstellung der Drucktinte 4a**

Zur Herstellung der zweikomponentigen Drucktinte wurde zunächst eine platinhaltige Komponente A und eine platinfreie Komponente B hergestellt.
Zur Herstellung der Komponente A wurden in einem Labormischer mit einem Fassungsvermögen von 10 L mit Zahn-Dissolverscheibe (Durchmesser 98 mm mit vier Zähnen), Balkenrührer und Abstreifer MWCNT (15 g) und 743 g der Rußvormischung in eine Mischung aus ViPo 1.000 (1097 g) und WACKER® KATALYSATOR OL (3,7 g) für 60 min bei 1800 rpm (Dissolver) und 50 rpm (Balkenrührer) eingemischt. Der doppelwandige Rührkessel wurde mit einem Thermostaten auf 19 °C Manteltemperatur eingestellt. Daraufhin wurde die Probe A unter Druck durch ein Metallgewebe (Maschenweite 50 pm) gepresst. Komponente B wurde aus MWCNT (15 g), 743 g der Rußvormischung, HPo 1000 (465 g), Vernetzer (260 g), Vipo 1000 (373 g) und 1-Ethinyl-1-cyclohexanol (2,61 g) analog zu A hergestellt. Daraufhin wurde die Probe B unter Druck durch ein Metallgewebe (Maschenweite 50 pm) gepresst. Zur Herstellung der Drucktinte 4a wurden die Komponenten A und B im Verhältnis 1:1 für 1 min mit einem Propellerrührer (800 rpm) gemischt. Es wurde eine homogene, schwarze Paste erhalten.

**Beispiel 12 Herstellung der Drucktinte 4b (nicht erfindungsgemäß)**

Drucktinte 4b wurde analog zu Drucktinte 4a hergestellt, mit dem Unterschied, dass die beiden Komponenten vor dem Mischen nicht durch ein Metallgewebe gepresst wurden.

**Beispiel 13 Herstellung der Drucktinte 5a**

Die Herstellung erfolgte analog Drucktinte 1a, mit dem Unterschied, dass 192 g Masterbatch M3 (entspricht 0,8 Gew% MWCNT), 192 g der Rußvormischung in einer Mischung aus ViPo 1.000 (21,2 g), HPo 1.000 (41,4 g) und Vernetzer (33,6 g) eingesetzt wurden. Die erhaltene Paste wurde unter Druck durch ein Metallgewebe (Maschenweite 50 pm) gepresst. Es wurde eine homogene, schwarze Paste erhalten.

**Beispiel 14 Herstellung der Drucktinte 5b (nicht erfindungsgemäß)**

Drucktinte 5b wurde analog zu Drucktinte 5a hergestellt, mit dem Unterschied, dass die Paste nicht durch ein Metallgewebe gepresst wurde.

**Beispiel 15 Herstellung der Drucktinte 6a**

Die Herstellung erfolgte analog Drucktinte 1a, mit dem Unterschied, dass 0,4 Gew.-% MWCNT (2,0 g), 280 g der Rußvormischung (entspricht 2,8 Gew% Ruß in der finalen Rezeptur) in einer Mischung aus ViPo 1.000 (48.1 g) und HPo 1.000 (150 g) eingesetzt wurden. Die erhaltene Paste wurde unter Druck durch ein Metallgewebe (Maschenweite 50 pm) gepresst. Es wurde eine homogene, schwarze Paste erhalten.

### Beispiel 16 Herstellung der Drucktinte 6b (nicht erfindungsgemäß)

Drucktinte 6b wurde analog zu Drucktinte 6a hergestellt, mit dem Unterschied, dass die Paste nicht durch ein Metallgewebe gepresst wurde.

### Beispiel 17 Herstellung der Drucktinte 7a

Die Herstellung erfolgte analog Drucktinte 1a, mit dem Unterschied, dass 1,0 Gew.-% MWCNT (5,0 g), 100 g der Rußvormischung (entspricht 1,0 Gew% Ruß in der finalen Rezeptur) in einer Mischung aus ViPo 1.000 (221 g) und HPo 1.000 (153 g) eingesetzt wurden. Die erhaltene Paste wurde unter Druck durch ein Metallgewebe (Maschenweite 50 pm) gepresst. Es wurde eine homogene, schwarze Paste erhalten.

### Beispiel 18 Herstellung der Drucktinte 7b (nicht erfindungsgemäß)

Drucktinte 7b wurde analog zu Drucktinte 7a hergestellt, mit dem Unterschied, dass die Paste nicht durch ein Metallgewebe gepresst wurde.

### Beispiel 19 Herstellung der Drucktinte 8a

Die Herstellung erfolgte analog Drucktinte 1a, mit dem Unterschied, dass 1,2 Gew.-% MWCNT (6,0 g), 200 g der Rußvormischung (entspricht 2,0 Gew% Ruß in der finalen Rezeptur) in einer Mischung aus ViPo 1.000 (124 g) und HPo 1.000 (150 g) eingesetzt wurden. Die erhaltene Paste wird unter Druck durch ein Metallgewebe (Maschenweite 50 $\mu$m) gepresst. Es wurde eine homogene, schwarze Paste erhalten.

### Beispiel 20 Herstellung der Drucktinte 8b (nicht erfindungsgemäß)

Drucktinte 8b wurde analog zu Drucktinte 8a hergestellt, mit dem Unterschied, dass die Paste nicht durch ein Metallgewebe gepresst wurde.

### Beispiel 21 Herstellung der Drucktinte 9a

Die Herstellung erfolgte analog Drucktinte 1a, mit dem Unterschied, dass 1,5 Gew.-% MWCNT (7,5 g), 100 g der Rußvormischung (entspricht 1,0 Gew% Ruß in der finalen Rezeptur) in einer Mischung aus ViPo 1.000 (221 g) und HPo 1.000 (152 g) eingesetzt wurden. Die erhaltene Paste wurde unter Druck durch ein Metallgewebe (Maschenweite 50 $\mu$m) gepresst. Es wurde eine homogene, schwarze Paste erhalten.

### Beispiel 22 Herstellung der Drucktinte 9b (nicht erfindungsgemäß)

Drucktinte 9b wurde analog zu Drucktinte 9a hergestellt, mit dem Unterschied, dass die Paste nicht durch ein Metallgewebe gepresst wurde.

### Beispiel 23 Herstellung der Drucktinte 10a

Die Herstellung erfolgte analog Drucktinte 1a, mit dem Unterschied, dass 1,2 Gew.-% MWCNT (2,4 g), 100 g der Rußvormischung (entspricht 2,5 Gew% Ruß in der finalen Rezeptur) in einer Mischung aus ViPo 1.000 (28,3 g) und HPo 1.000 (59,3 g), Vernetzer (8 g) Pt-Katalysator (160 mg) und 1-Ethinyl-1-cyclohexanol (12°mg) eingesetzt wurden. Die erhaltene Paste wurde unter Druck durch ein Metallgewebe (Maschenweite 50 $\mu$m) gepresst. Es wurde eine homogene, schwarze Paste erhalten.

### Beispiel 24 Herstellung der Drucktinte 10b (nicht erfindungsgemäß)

Die Drucktinte 10b wurde analog zu Drucktinte 10a hergestellt, mit dem Unterschied, dass die Paste nicht durch ein Metallgewebe gepresst wurde.

**Beispiel 25 Herstellung der Drucktinte 11a**

Die Herstellung erfolgte analog Drucktinte 1a, mit dem Unterschied, dass 2,0 Gew.-% MWCNT (10 g), 300 g der Rußvormischung (entspricht 3,0 Gew% Ruß in der finalen Rezeptur) in einer Mischung aus ViPo 1.000 (25,3 g) und HPo 1.000 (144 g) eingesetzt wurden. Die erhaltene Paste wird unter Druck durch ein Metallgewebe (Maschenweite 50 pm) gepresst. Es wurde eine homogene, schwarze Paste erhalten. Es wurde eine homogene, schwarze Paste erhalten.

**Beispiel 26 Herstellung der Drucktinte 11b (nicht erfindungsgemäß)**

Die Drucktinte 11b wurde analog zu Drucktinte 11a hergestellt, mit dem Unterschied, dass die Paste nicht durch ein Metallgewebe gepresst wurde.

Druckversuche

Der LIFT Prozess wurde wie in WO2020156632 beschrieben durchgeführt. Das Drucken erfolgte mit einem gängigen Laser-Gravursystem der Firma TROTEC Laser Deutschland GmbH. Zur Anwendung kommt dabei ein System der Baureihe Speedy 100flexx 60/20 mit Dual Laserquelle (60 W 10,6 $\mu$m CO2 Laser; 20 W 1064 nm Faser-Laser). Als Träger und Druckmassenträger werden gängige Quarzglasplatten (300x300x3 mm) der Firma GVB GmbH Solutions in Glass, Deutschland, verwendet. Zur Aufbringung des Druckmassenfilmes wird ein ZAA 2300 Automatisches Filmziehgerät mit einem ZUA 2000 Universal-Applikator der Firma Zehntner GmbH, Schweiz, verwendet.
Mit dem Rakelsystem wird einseitig auf einer Quarzglasscheibe eine homogene Schicht in einer Dicke von 60 $\mu$m und in den Abmessungen 200x 200mm mittig aufgerakelt. Die Randbereiche der Scheibe bleiben dabei frei von Druckmasse. In den Schneidraum des Lasers wird auf eine unbeschichtete Glasscheibe durch einen Wasserfilm fixierte Siliconfolie (ELASTOSIL<®>-Film mit 100 $\mu$m Dicke, erhältlich bei der WACKER Chemie AG) als zu bedruckende Fläche eingelegt. Die beschichtete Scheibe wird mit der Beschichtungsseite der unbeschichteten Scheibe zugewandt, in einem Abstand von 200 $\mu$m auf der ersten Scheibe platziert. Der Abstand wird dabei durch Abstandshalter wie beispielsweise 100 $\mu$m Mikroskopplatten eingestellt. Als Druckvorlage in der Steuersoftware des Lasersystems, ist eine flächig gefüllte Geometrie ohne Graubereiche und Schattierungen zu wählen. Weiter ist die Laserleistung im Schneidmodus Faserlaser zwischen 40-60 % bei einem 20 W Laser ausreichend. Der Laserspeed ist zwischen 50 und 70 % zu wählen. Der Fokuspunkt sollte ca. 4 bis 4,5 mm oberhalb der Grenzfläche Beschichtung bzw. der Quarzglasplatte liegen. Die gewählten Geometrien konnten so durch den Laser auf die Siliconfolie transferiert werden.

Beurteilung der Drucke

Die Oberfläche der gedruckten Elektrode wurde optisch beurteilt. Die Schichten, die mit den Drucktinten 1a, 1b, 2a, 3a, 4a, 5a, 6a, 7a, 8a, 9a, 10a und 11a gedruckt wurden, waren glatt, glänzend und frei von herausstehenden Zacken. Diese Drucktinten sind somit als Elektrodenmaterial für mehrlagige Systeme wie z.B. in dielektrischen Elastomersensoren, -aktoren und -generatoren besonders gut geeignet.
Mit den Drucktinten 1c, 2b, 3b, 4b, 5b, 6b, 7b, 8b, 9b, 10b und 11b gedruckte Schichten weisen Oberflächen mit aus der Schicht heraustretenden Zacken auf und sind somit für mehrlagige Systeme ungeeignet.
Die folgende Tabelle stellt die in den Beispielen verwendeten Mengen an MWCNT, Ruß, die zur Filtration eingesetzten Maschenweiten sowie die Ergebnisse der Messungen gegenüber.

| Drucktinte Nr. | MWCNT (Gew-%) | Ruß (Gew-%) | Maschen weite [pm] | Viskosi tät [Pas] | G' [kPa] | spez. Widerstand [$\Omega$*cm] | R/R$_0$ |
|---|---|---|---|---|---|---|---|
| 1a | | | 50 | 79 | 11 | 8, 8 | 1, 6 |
| 1b | 0, 8 | 2, 0 | 25 | 79 | 11 | 8, 8 | 1, 6 |
| 1c | | | - | 79 | 11 | 8, 8 | 1, 6 |
| 2a | 0, 8 | 2, 0 | 50 | 66 | 8, 7 | 11 | 1, 6 |
| 2b | | | - | 69 | 8,5 | 11 | 1, 6 |
| 3a | 0, 8 | 2, 0 | 50 | 77 | 9, 3 | 9, 5 | 1, 6 |
| 3b | | | - | 75 | 9, 0 | 9, 5 | 1, 6 |

(fortgesetzt)

| Drucktinte Nr. | MWCNT (Gew-%) | Ruß (Gew-%) | Maschenweite [pm] | Viskosität [Pas] | G' [kPa] | spez. Widerstand [Ω*cm] | R/R$_0$ |
|---|---|---|---|---|---|---|---|
| 4a | 0, 8 | 2, 0 | 50 | 80 | 10 | 9, 5 | 1, 6 |
| 4b | | | - | 80 | 10 | 9, 5 | 1, 6 |
| 5a | 0, 8 | 2, 0 | 50 | 81 | 9, 5 | 9, 0 | 1, 6 |
| 5b | | | - | 81 | 9, 5 | 9, 0 | 1, 6 |
| 6a | 0,4 | 2,8 | 50 | 67 | 6, 7 | 18 | 1, 8 |
| 6b | | | - | 67 | 6, 6 | 18 | 1, 8 |
| 7a | 1, 0 | 1, 0 | 50 | 51 | 6, 3 | 19 | 1, 2 |
| 7b | | | - | 51 | 6, 3 | 19 | 1, 2 |
| 8a | 1,2 | 2, 0 | 50 | 100 | 19 | 6, 8 | 1, 2 |
| 8b | | | - | 100 | 18 | 6, 8 | 1, 2 |
| 9a | 1,5 | 1, 0 | 50 | 80 | 15 | 5, 1 | 1, 2 |
| 9b | | | - | 79 | 15 | 5, 1 | 1, 2 |
| 10a | 1,2 | 2,5 | 50 | 151 | 23 | 7, 8 | 1, 2 |
| 10b | | | - | 151 | 24 | 7, 8 | 1, 2 |
| 11a | 2,0 | 3, 0 | 50 | 300 | 88 | 3, 9 | 1, 1 |
| 11b | | | - | 300 | 88 | 3, 9 | 1, 1 |

**Patentansprüche**

1.  Verfahren zur Herstellung einer elektrisch leitfähigen, vernetzenden Silikonelastomerzusammensetzung,

    enthaltend:

    - 0,5 bis 3,0 Gew.% Leitfähigkeitsruß,
    - 0,1 bis 3,0 Gew.% mehrwandige Kohlenstoffnanoröhren (MWCNT),
    - kein Lösungsmittel,

    mit der Maßgabe, dass

    a) wenn die Silikonelastomerzusammensetzung einkomponentig formuliert wird, alle Komponenten in einem oder in mehreren Schritten vermischt werden und anschließend eine Druckfiltration durch ein Metallgewebe mit einer Maschenweite von höchstens 200 μm erfolgt, oder dass
    b) wenn die Silikonelastomerzusammensetzung zweikomponentig formuliert wird, jeweils nur die Komponenten der A- bzw. der B-Zusammensetzung in einem oder in mehreren Schritten vermischt werden und anschließend jeweils eine Druckfiltration der A- bzw. der B-Zusammensetzung durch ein Metallgewebe mit einer Maschenweite von höchstens 200 μm erfolgt.

2.  Verfahren gemäß Anspruch 1, **dadurch gekennzeichnet, dass** es eine elektrisch leitfähige, additionsvernetzende Silikonelastomerzusammensetzung ist, und folgende Kompononenten enthält:

    (A) mindestens eine lineare Verbindung, die Reste mit aliphatischen Kohlenstoff-Kohlenstoff-Mehrfachbindungen aufweist,
    (B) mindestens eine -bevorzugt lineare - Organopolysiloxan Verbindung mit Si-gebundenen Wasserstoffatomen, oder anstelle von (A) und (B) oder zusätzlich zu (A) und (B)
    (C) mindestens eine lineare Organopolysiloxan Verbindung, die Si-C-gebundene Reste mit aliphatischen Kohlenstoff-Kohlenstoff Mehrfachbindungen und Si-gebundene Wasserstoffatome aufweist, und
(D) mindestens einen Hydrosilylierungskatalysator.

3. Elektisch leitfähige vernetzende Silikonelastomerzusammensetzung erhältlich nach einem der Verfahren gemäß den Ansprüchen 1 bis 2.

4. Verwendung der leitfähigen vernetzenden Silikonelastomerzusammensetzung gemäß Anspruch 3 als elektrisch leitfähige Drucktinte in kontaktlosen Druckverfahren zur Herstellung von elektrisch leitfähigen Elastomeren auf elastischen Trägern.

5. Verwendung gemäß Anspruch 4, **dadurch gekennzeichnet, dass** das kontaktlose Druckverfahren der Laser-Transferdruck ist.

6. Verwendung gemäß Anspruch 4 und 5, **dadurch gekennzeichnet, dass** die hergestellten elektrisch leitfähigen Elastomere auf elastischen Trägern Elektroden für dielektrische Elastomersensoren, -aktoren und -generatoren und EAP-Schichtsysteme sind.


**Claims**

1. Process for producing an electrically conductive, crosslinkable silicone elastomer composition containing:

   - 0.5% to 3.0% by weight of conductivity carbon black,
   - 0.1% to 3.0% by weight of multiwalled carbon nanotubes (MWCNTs),
   - no solvent,

   with the proviso that

   a) if the silicone elastomer composition is formulated as a one-component system all components are mixed in one or more steps and subsequently a pressure filtration through a metal fabric having a mesh size of at most 200 $\mu$m is carried out or that
   b) if the silicone elastomer composition is formulated as a two-component system in each case only the components of the A or the B composition are mixed in one or more steps and subsequently in each case a pressure filtration of the A or the B composition through a metal fabric having a mesh size of at most 200 $\mu$m is carried out.

2. Process according to Claim 1, **characterized in that** it is an electrically conductive, addition-crosslinkable silicone elastomer composition and contains the following components:

   (A) at least one linear compound comprising radicals having aliphatic carbon-carbon multiple bonds,
   (B) at least one - preferably linear - organopolysiloxane compound having Si-bonded hydrogen atoms,
   or, instead of (A) and (B) or in addition to (A) and (B),
   (C) at least one linear organopolysiloxane compound comprising Si-C-bonded radicals having aliphatic carbon-carbon multiple bonds and Si-bonded hydrogen atoms, and
   (D) at least one hydrosilylation catalyst.

3. Electrically conductive crosslinkable silicone elastomer composition obtainable by a process according to Claims 1 to 2.

4. Use of the conductive crosslinkable silicone elastomer composition according to Claim 3 as electrically conductive printing ink in contactless printing processes for producing electrically conductive elastomers on elastic carriers.

5. Use according to Claim 4, **characterized in that** the contactless printing process is laser transfer printing.

6. Use according to Claims 4 and 5, **characterized in that** the produced electrically conductive elastomers on elastic carriers are electrodes for dielectric elastomer sensors, actuators and generators and EAP layer systems.

**Revendications**

1. Procédé de fabrication d'une composition d'élastomère de silicone réticulable conductrice de l'électricité, contenant :

   - 0,5 à 3,0 % en poids de noir de carbone conducteur,
   - 0,1 à 3,0 % en poids de nanotubes de carbone multi-parois (MWCNT),
   - pas de solvant,

   à la condition que

   a) quand la composition d'élastomère de silicone est formulée en mono-composant, tous les composants soient mélangés en une ou plusieurs étapes, puis qu'une filtration sous pression ait lieu à travers un tissu métallique ayant une ouverture de maille d'au plus 200 $\mu$m, ou en ce que
   b) quand la composition d'élastomère de silicone est formulée en bicomposant, seuls les composants de la composition A ou B soient mélangés en une ou plusieurs étapes, puis qu'une filtration sous pression de la composition A ou B ait lieu à travers un tissu métallique ayant une ouverture de maille d'au plus 200 $\mu$m.

2. Procédé selon la revendication 1, **caractérisé en ce qu'**il s'agit d'une composition d'élastomère de silicone réticulable par addition, conductrice de l'électricité, et contenant les composants suivants :

   (A) au moins un composé linéaire, qui comprend des radicaux comportant des liaisons multiples carbone-carbone aliphatiques,
   (B) au moins un composé organosiloxane - de préférence linéaire - comportant des atomes d'hydrogène liés à Si, ou, à la place de (A) et (B) ou en plus de (A) et (B)
   (C) au moins un composé organopolysiloxane linéaire qui comprend des radicaux liés à SiC, comportant des liaisons multiples carbone-carbone aliphatiques et des atomes d'hydrogène liés à Si, et
   (D) au moins un catalyseur d'hydrosilylation.

3. Composition d'élastomère de silicone réticulable conductrice de l'électricité pouvant être obtenue par l'un des procédés selon les revendications 1 à 2.

4. Utilisation de la composition d'élastomère de silicone réticulable conductrice selon la revendication 3 comme encre d'impression conductrice de l'électricité dans un procédé d'impression sans contact pour la fabrication d'élastomère conducteur de l'électricité sur des supports élastiques.

5. Utilisation selon la revendication 4, **caractérisée en ce que** le procédé d'impression sans contact est l'impression transfert par laser.

6. Utilisation selon les revendications 4 et 5, **caractérisée en ce que** les élastomères conducteurs de l'électricité fabriqués sont, sur des supports élastiques, des électrodes pour capteurs, actionneurs et générateurs élastomères diélectriques et systèmes de couches EAP.

**IN DER BESCHREIBUNG AUFGEFÜHRTE DOKUMENTE**

**In der Beschreibung aufgeführte Patentdokumente**

- US 9253878 B
- US 2016351289 A
- CN 103160128
- US 2014060903 A
- WO 2009153192 A2
- WO 2010069900 A1
- WO 2015181810 A1
- WO 2011161598 A1
- US 20140014403 A1
- WO 2015127290 A1
- EP 2050768 B1
- WO 2020156632 A

**In der Beschreibung aufgeführte Nicht-Patentliteratur**

- Inkjet 3D printing of UV and thermal cure silicone elastomers for dielectric elastomer actuators. **DAVID MCCOUL et al.** SMART MATERIALS AND STRUCTURES. IOP PUBLISHING LTD., 10 November 2017, vol. 26, 125022
- *CHEMICAL ABSTRACTS*, 78-27-3